(19) **Europäisches Patentamt**

**European Patent Office**

**Office européen des brevets**

(11) **EP 1 411 577 B1**

(12) **FASCICULE DE BREVET EUROPEEN**

(45) Date de publication et mention
de la délivrance du brevet:
**28.12.2005 Bulletin 2005/52**

(51) Int Cl.⁷: **H01M 10/42**, G01R 31/36

(21) Numéro de dépôt: **03300163.7**

(22) Date de dépôt: **16.10.2003**

(54) **Dispositif pour diagnostiquer l'état de corrosion d'une batterie notamment de véhicule automobile**

Vorrichtung zur Feststellung des Korrosionszustandes einer Batterie, insbesondere einer Kraftfahrzeugbatterie

Device for diagnosing the state of corrosion of a battery, in particular one of a motor vehicle

(84) Etats contractants désignés:
**BE DE ES FR GB IT**

(30) Priorité: **16.10.2002 FR 0212871**

(43) Date de publication de la demande:
**21.04.2004 Bulletin 2004/17**

(73) Titulaire: **Renault s.a.s.**
**92100 Boulogne Billancourt (FR)**

(72) Inventeurs:
• **Franco, Patrice**
**91320 Wissous (FR)**
• **Hiron, Christian**
**78690 Les Essarts le Roi (FR)**

(74) Mandataire: **Davies, Owen Robert Treharne et al**
**RENAULT TECHNOCENTRE**
**Département Propriété Intellectuelle**
**Sce 00267 TCR GRA 2 36**
**1, avenue du Golf**
**78288 Guyancourt cedex (FR)**

(56) Documents cités:
**EP-A- 0 568 767**        **DE-A- 3 231 363**
**US-A- 2 324 424**

• **PATENT ABSTRACTS OF JAPAN vol. 015, no. 434 (E-1129), 6 novembre 1991 (1991-11-06) & JP 03 182063 A (SHIN KOBE ELECTRIC MACH CO LTD), 8 août 1991 (1991-08-08)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention se rapporte à un dispositif pour diagnostiquer l'état de corrosion d'une batterie notamment de véhicule automobile.

On connaît de la technique antérieure un certain nombre de méthodes pour estimer l'état de charge d'une batterie. Dans quelques une de ces méthodes, classiquement, on mesure une variation de tension correspondant à une variation de courant aux bornes de la batterie pour une température donnée, et on déduit de cette mesure une image de la résistance interne de la batterie. On compare ensuite cette image à une base de données préétablie, et on déduit de cette comparaison l'état de charge de la batterie. Mais, lorsqu'une batterie est presque complètement chargée, sa résistance interne est sensiblement indépendante du degré de corrosion de ses électrodes.

Dans le document EP-0568767, le système proposé utilise une tension alternative fournie par un dispositif externe pour obtenir l'état de la batterie. Dans le document DE-3231363, un mode de réalisation utilise un courant alternatif fourni par un dispositif externe. Un des inconvénients des ces solutions est qu'il faut fournir une source externe de tension alternative.

Dans le document DE-3231363, un second mode de réalisation comprend un dispositif dans lequel deux témoins sont séparés. La corrosion de ces deux témoins entraîne leur expansion et rentrent en contact pour fermer un circuit d'alerte. Un des inconvénients de ce système est qu'un dispositif compliqué doit être mis en oeuvre pour loger les deux témoins qui vont se corroder.

Bien que ces méthodes soient en général assez efficaces, elles ne permettent pas de diagnostiquer de manière fiable une cause très fréquente de défaillance des batteries, à savoir la corrosion de certaines des électrodes due à l'électrolyte (en général de l'acide sulfurique).

La présente invention a pour but de fournir des moyens améliorés pour diagnostiquer de manière fiable le degré de corrosion des électrodes d'une batterie. On atteint ce but de l'invention avec un dispositif pour diagnostiquer l'état de corrosion d'une batterie comprenant des électrodes immergées dans un électrolyte, caractérisé en ce que lesdits moyens électriques comprennent le conducteur témoin en série, ledit conducteur témoin étant adapté à changer un circuit électrique fermé en un circuit électrique ouvert quand ledit degré de corrosion dépasse ledit seuil prédéterminé.

Grâce à ces caractéristiques, on peut obtenir une indication fiable sur le degré de corrosion de certaines des électrodes de la batterie sans qu'il soit nécessaire de recourir à quelque mesure de tension ou de courant aux bornes de la batterie que ce soit, et sans utiliser des moyens de calculateur. Un des avantages de ce système est qu'il utilise une structure simple et n'a pas besoin de courant alternatif fourni par un dispositif externe.

Suivant d'autres caractéristiques du dispositif selon l'invention :

- le témoin se corrode jusqu'à ouvrir ledit circuit électrique;
- les moyens électriques comprennent des moyens pour appliquer une tension aux bornes dudit élément conducteur témoin, et pour vérifier si cette tension a pour effet de faire circuler un courant dans ledit élément conducteur témoin;
- les moyens électriques comprennent un circuit destiné à être interposé entre les deux bornes de ladite batterie;
- les moyens électriques comprennent un dispositif d'indication de présence de courant à travers ledit témoin, par exemple une diode électroluminescente;
- le circuit comprend en outre une résistance montée en série avec ledit témoin, ladite résistance étant adaptée d'empêcher l'établissement d'un courant d'électrolyse pouvant circuler après l'ouverture dudit témoin;
- le élément conducteur témoin est formé dans un alliage métallique;
- les moyens électriques comprennent un interrupteur pour initialiser un test de circuit à travers le témoin.

La présente invention se rapporte également à une batterie comprenant des électrodes immergées dans un électrolyte, remarquable en ce qu'elle est équipée d'un dispositif conforme à ce qui précède pour diagnostiquer le degré de corrosion de parties de certaines desdites électrodes.

Suivant d'autres caractéristiques de cette batterie :

- le dispositif est intégré au couvercle de ladite batterie;
- les certaines électrodes sont des anodes;
- les parties d'électrodes sont des grilles métalliques desdites anodes;
- l'élément conducteur témoin dudit dispositif est directement relié de manière conductrice à la borne positive de ladite batterie.

L'invention va maintenant être décrite à titre d'exemple illustratif et non limitatif avec les références aux figures annexées dans lesquelles:

- la figure 1 est une vue partielle en coupe d'une batterie équipée du dispositif selon l'invention,
- la figure 2 est une vue en coupe du dispositif selon l'invention lorsqu'il se trouve dans un premier état correspondant à un degré de corrosion de certaines des électrodes inférieur à un seuil prédéterminé,
- la figure 3 est une vue en coupe du dispositif selon l'invention lorsqu'il se trouve dans un deuxième état correspondant à un degré de corrosion desdites électrodes supérieur à un seuil prédéterminé, et

- la figure 4 est une vue schématique mettant en évidence des moyens électriques de signalement du degré de corrosion desdites électrodes.

Dans ce qui suit, on va décrire le dispositif selon l'invention dans le cas particulier où il est installé sur une batterie notamment de véhicule automobile, mais il va de soi qu'un tel dispositif pourrait être installé sur n'importe plusieurs types d'accumulateurs.

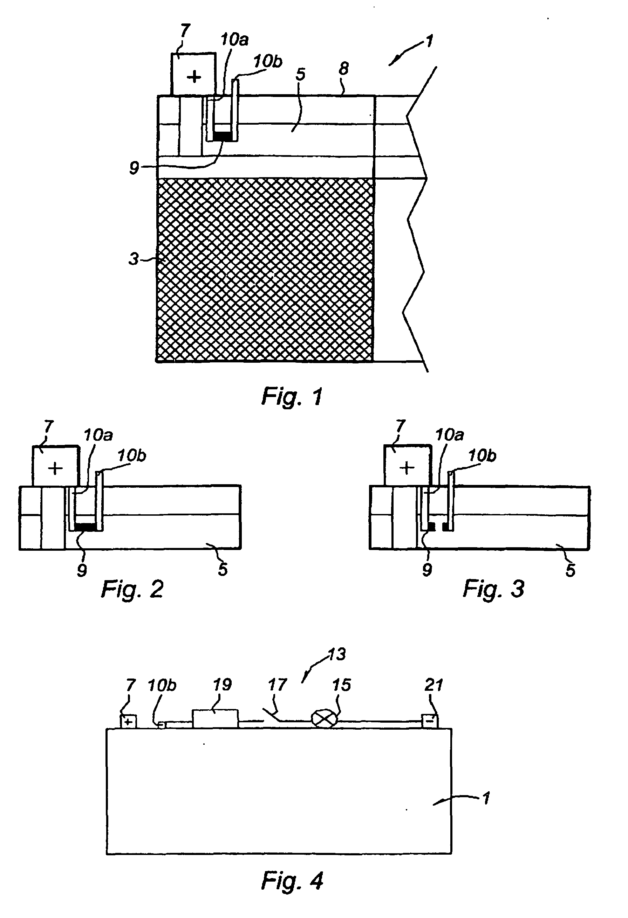

On se reporte à présent à la figure 1, sur laquelle on a représenté une batterie 1 comprenant un faisceau d'électrodes 3 immergées dans un électrolyte 5. Le faisceau d'électrodes 3 comprend des électrodes négatives (ou cathodes) et des électrodes positives (ou anodes) disposées en sandwich de manière alternée. Classiquement, les cathodes peuvent être formées par des plaques de plomb, et les anodes peuvent être formées par des grilles métalliques supportant du peroxyde de plomb.

Les cathodes et les anodes sont reliées en série respectivement à des bornes négative (non représentée) et positive 7 fixées sur la partie supérieure 8 de la batterie 1. Classiquement, l'électrolyte 5 peut être formé par de l'acide sulfurique légèrement dilué. L'équation chimique gouvernant alors la décharge de ce type de batterie dite « au plomb » est alors :

$$Pb + PbO_2 + 2H_2SO_4 \rightarrow 2SO_4Pb + 2H_2O$$

Comme cela est visible sur la figure 1, le dispositif selon invention comprend un élément conducteur témoin 9 qui trempe en permanence dans la partie de l'électrolyte 5 qui se trouve au-dessus du faisceau d'électrodes 3. Cet élément conducteur témoin 9 comprend une première borne conductrice 10a qui est reliée à la borne positive 7 de la batterie 1, et une deuxième borne conductrice 10b qui dépasse de la partie supérieure 8 de la batterie 1. L'élément conducteur témoin 9 peut être un fil d'alliage équivalent ou proche de celui qui compose les grilles métalliques des anodes.

Pour plus de détails sur ce dispositif, on se reporte à présent à la figure 2, sur laquelle on a représenté ce dispositif dans un premier état. Dans ce premier état, l'élément conducteur témoin 9 établit un chemin conducteur continu et en série entre les deux bornes conductrices 10a et 10b, c'est à dire un circuit électrique fermé.

Dans le deuxième état représenté à la figure 3, l'élément conducteur témoin présente une discontinuité, de sorte qu'il n'assure plus de chemin conducteur entre les deux bornes conductrices 10a et 10b, c'est à dire un circuit électrique ouvert. L'élément conducteur témoin 9 est calibré, c'est-à-dire dimensionné pour passer de son premier état à son deuxième état lorsque son degré de corrosion dépasse un seuil prédéterminé, correspondant à un degré de corrosion des grilles des anodes de la batterie 1 au-delà duquel on estime que la batterie doit être remplacée.

En se reportant à la figure 4, on voit que le dispositif selon l'invention comprend également des moyens électriques de signalement du degré de corrosion de l'élément conducteur témoin 9. Ces moyens peuvent comprendre un circuit électrique 13 comprenant une diode électroluminescente 15, un interrupteur 17 et une résistance 19 interposés entre la borne négative 21 de la batterie 1 et la borne conductrice 10b de l'élément conducteur témoin 9.

Le mode de fonctionnement et les avantages du dispositif selon l'invention résultent clairement de la description qui précède. Tant que le dispositif selon l'invention se trouve dans le premier état représenté à la figure 2, l'élément conducteur témoin 9 peut permettre à un courant électrique de circuler entre les deux bornes conductrices 10a et 10b, circuit fermé.

Ainsi, dans ce premier état, lorsqu'on ferme l'interrupteur 17, la diode électroluminescente 15 est reliée par un chemin conducteur à la fois aux bornes positive et négative de la batterie 1, de sorte qu'elle s'allume. Lorsque le dispositif selon l'invention se trouve dans le deuxième état représenté à la figure 2, l'élément conducteur témoin 9 ne permet pas à un courant électrique de circuler entre les deux bornes conductrices 10a et 10b, circuit ouvert. Ainsi, dans ce deuxième état, lorsqu'on ferme l'interrupteur 17, la diode électroluminescente 15 n'est traversée par aucun courant et demeure éteinte.

Compte tenu du calibrage approprié de l'élément conducteur témoin 9, on comprend donc que tant que la diode électroluminescente 15 s'allume lorsqu'on ferme l'interrupteur 17, cela signifie que les anodes de la batterie 1 n'ont pas atteint un degré de corrosion au-delà duquel on estime que la batterie doit être changée. Au contraire, lorsque la diode électroluminescente 15 demeure éteinte lorsqu'on ferme l'interrupteur 17, il faut envisager de changer la batterie. La fonction de l'interrupteur est donc d'initialiser un test de circuit à travers le témoin 9.

On notera que le rôle de la résistance 19 est d'empêcher l'établissement d'un courant d'électrolyse pouvant circuler entre les deux extrémités de l'élément conducteur témoin 9 une fois que ce dernier a rompu.

Du fait que l'élément conducteur témoin 9 est soumis rigoureusement aux mêmes conditions que les grilles métalliques des anodes de la batterie 1, tant en ce qui concerne le contact avec l'électrolyte 5 qu'en ce qui concerne la température (laquelle peut être élevée lorsque la batterie est située près d'un moteur), on peut considérer que le degré de corrosion de cet organe témoin donne une image fidèle du degré de corrosion des anodes de la batterie 1, et donc que le dispositif selon l'invention offre une fiabilité tout à fait satisfaisante.

Comme on peut le comprendre à la lumière de ce qui précède, le dispositif selon l'invention ne nécessite aucune mesure de tension ou de courant aux bornes de la batterie, et ne fait intervenir aucun moyen complexe tel qu'un calculateur électronique ou une source externe de courant alternatif. Le dispositif selon l'invention est donc simple et peu coûteux, ce qui permet d'envisager de le monter de série sur les batteries sans qu'il soit nécessaire d'augmenter de manière significative le prix de ces dernières.

Ce dispositif peut être facilement intégré au couvercle de la batterie lors de sa fabrication. Ce dispositif est très souple car il peut être utilisé soit par le véhicule directement qui va simplement constater la continuité ou non du circuit électrique 13, soit par l'utilisateur qui n'aura qu'à agir sur l'interrupteur 17 pour s'assurer de l'état de la batterie 1.

**Revendications**

1. Dispositif pour diagnostiquer l'état de corrosion d'une batterie (1) comprenant des électrodes (3) immergées dans un électrolyte (5), un élément conducteur témoin (9) destiné à être immergé dans ledit électrolyte (5) et dont le degré de corrosion est représentatif du degré de corrosion de parties de certaines desdites électrodes (3), et des moyens électriques (15, 17, 19) pour signaler quand le degré de corrosion dudit élément conducteur témoin (9) dépasse un seuil prédéterminé correspondant à un degré de corrosion desdites parties au-delà duquel on estime que ladite batterie (1) doit être remplacée, **caractérisé en ce que** lesdits moyens électriques (15, 17, 19) comprennent le conducteur témoin (9) en série, ledit conducteur témoin étant adapté à changer un circuit électrique fermé en un circuit électrique ouvert quand ledit degré de corrosion dépasse ledit seuil prédéterminé.

2. Dispositif selon la revendication 1, **caractérisé en ce que** ledit témoin (9) se corrode jusqu'à ouvrir ledit circuit électrique.

3. Dispositif selon l'une des revendications 1 ou 2, **caractérisé en ce que** lesdits moyens électriques (15, 17, 19) comprennent des moyens pour appliquer une tension aux bornes dudit élément conducteur témoin (9), et pour vérifier si cette tension a pour effet de faire circuler un courant dans ledit élément conducteur témoin (9).

4. Dispositif selon l'une des revendications précédentes, **caractérisé en ce que** lesdits moyens électriques comprennent un circuit destiné à être interposé entre les deux bornes (7, 8) de ladite batterie (1).

5. Dispositif selon l'une des revendications précédentes, **caractérisé en ce que** lesdits moyens électriques comprennent un dispositif d'indication de présence de courant à travers ledit témoin (9), par exemple une diode électroluminescente (15).

6. Dispositif selon la revendications 5, **caractérisé en ce que** ledit circuit comprend en outre une résistance (19) montée en série avec ledit témoin (9), ladite résistance (19) étant adaptée d'empêcher l'établissement d'un courant d'électrolyse pouvant circuler après l'ouverture dudit témoin (9).

7. Dispositif selon l'une des revendications précédentes, **caractérisé en ce que** ledit élément conducteur témoin (9) est formé dans un alliage métallique.

8. Dispositif selon l'une des revendications précédentes, **caractérisé en ce que** lesdits moyens électriques (15, 17, 19) comprennent un interrupteur (17) pour initialiser un test de circuit à travers le témoin (9).

9. Batterie (1) comprenant des électrodes (3) immergées dans un électrolyte (5), **caractérisée en ce qu'**elle est équipée d'un dispositif conforme à l'une quelconque des revendications précédentes pour diagnostiquer le degré de corrosion de parties de certaines desdites électrodes (3).

10. Batterie (1) selon la revendication 9, **caractérisée en ce que** ledit dispositif est intégré au couvercle de ladite batterie (1).

11. Batterie (1) selon l'une des revendications 9 ou 10, **caractérisée en ce que** lesdites certaines électrodes sont des anodes.

12. Batterie (1) selon la revendication 11, **caractérisée en ce que** lesdites parties d'électrodes sont des grilles métalliques desdites anodes.

13. Batterie selon l'une des revendications 9 à 12, **caractérisée en ce que** l'élément conducteur témoin (9) dudit dispositif est directement relié de manière conductrice à la borne positive (7) de ladite batterie.

**Patentansprüche**

1. Vorrichtung zur Diagnose des Korrosionszustandes einer Batterie (1) mit in einem Elektrolyt (5) getauchten Elektroden (3), einem leitenden Meldeglied (9), das dazu bestimmt ist, in das Elektrolyt (5) getaucht zu werden, und dessen Korrosionsgrad repräsentativ für den Korrosionsgrad von Teilen bestimmter der Elektroden (3) ist, und elektrischen Mitteln (15, 17, 19), um anzuzeigen, wenn der Korrosionsgrad des leitenden Meldegliedes (9) einen vorbestimmten Grenzwert überschreitet, der einem Korrosionsgrad der Teile entspricht, über welchem davon ausgegangen wird, dass die Batterie (1) ersetzt werden muss, **dadurch gekennzeichnet, dass** die elektrischen Mittel (15, 17, 19) den leitenden Melder (9) in Serie umfassen, wobei der leitende Melder darauf angepasst ist, einen geschlossenen elektrischen Schaltkreis in einen offenen elektrischen Schaltkreis umzuwandeln, wenn der Korrosionsgrad den vorbestimmten Grenzwert überschreitet.

2. Vorrichtung gemäß Anspruch 1, **dadurch gekennzeichnet, dass** der Melder (9) korrodiert, bis er den elektrischen Schaltkreis öffnet.

3. Vorrichtung gemäß einem der Ansprüche 1 oder 2, **dadurch gekennzeichnet, dass** die elektrischen Mittel (15, 17, 19) Mittel zum Anlegen einer Spannung an den Anschlüssen des leitenden Meldegliedes (9) umfassen, und zum Nachprüfen, ob diese Spannung einen Stromfluss im leitenden Meldeglied (9) bewirkt.

4. Vorrichtung gemäß einem der vorhergehenden Ansprüche, **dadurch gekennzeichnet, dass** die elektrischen Mittel einen Schaltkreis umfassen, der dazu bestimmt ist, zwischen die zwei Pole (7, 8) der Batterie (1) gesetzt zu werden.

5. Vorrichtung gemäß einem der vorhergehenden Ansprüche, **dadurch gekennzeichnet, dass** die elektrischen Mittel eine Vorrichtung zur Anzeige der Anwesenheit eines Stroms durch den Melder (9) umfassen, z.B. eine elektro-lumineszierende Diode (15).

6. Vorrichtung gemäß Anspruch 5, **dadurch gekennzeichnet, dass** der Schaltkreis außerdem einen mit dem Melder (9) in Serie montierten Widerstand (19) umfasst, wobei der Widerstand (19) darauf angepasst ist, den Aufbau eines Elektrolysestroms zu verhindern, der nach Öffnung des Melders (9) fließen kann.

7. Vorrichtung gemäß einem der vorhergehenden Ansprüche, **dadurch gekennzeichnet, dass** das leitende Meldeglied (9) aus einer metallischen Legierung gebildet ist.

8. Vorrichtung gemäß einem der vorhergehenden Ansprüche, **dadurch gekennzeichnet, dass** die elektrischen Mittel (15, 17, 19) einen Schalter (17) zur Initialisierung eines Schaltkreistestes durch den Melder (9) umfassen.

9. Batterie (1) mit in einem Elektrolyt (5) getauchten Elektroden (3), **dadurch gekennzeichnet, dass** sie mit einer Vorrichtung gemäß einem der vorhergehenden Ansprüche zur Diagnose des Korrosionsgrades von Teilen bestimmter der Elektroden (3) ausgerüstet ist.

10. Batterie (1) gemäß Anspruch 9, **dadurch gekennzeichnet, dass** die Vorrichtung in den Deckel der Batterie (1) integriert ist.

11. Batterie (1) gemäß einem der Ansprüche 9 oder 10, **dadurch gekennzeichnet, dass** die bestimmten Elektroden Anoden sind.

12. Batterie (1) gemäß Anspruch 11, **dadurch gekennzeichnet, dass** die Teile der Elektroden Metallgitter der Anoden sind.

13. Batterie gemäß einem der Ansprüche 9 bis 12, **dadurch gekennzeichnet, dass** das leitende Meldeglied (9) der Vorrichtung direkt auf leitende Weise mit dem Pluspol (7) der Batterie verbunden ist.

**Claims**

1. A device for diagnosing the state of corrosion of a battery (1) comprising electrodes (3) immersed in an electrolyte (5), an indicating conductor element (9) which is intended to be immersed in said electrolyte (5) and of which the degree of corrosion is representative of the degree of corrosion of parts of some of said electrodes (3), and electrical means (15, 17, 19) for signalling when the degree of corrosion of said indicating conductor element (9) exceeds a predetermined threshold corresponding to a degree of corrosion of said parts, beyond which it is considered that said battery (1) has to be replaced, **characterised in that** said electrical means (15, 17, 19) comprise the indicating conductor (9) in series, said indicating conductor being adapted to change a closed electrical circuit into an open electrical circuit when said degree of corrosion exceeds said predetermined threshold.

2. A device according to claim 1 **characterised in that** said indicating member (9) corrodes until said electrical circuit is opened.

3. A device according to one of claims 1 and 2 **characterised in that** said electrical means (15, 17, 19) comprise means for applying a voltage to the terminals of said indicating conductor element (9) and for checking if said voltage has the effect of causing a current to flow in said indicating conductor element (9).

4. A device according to one of the preceding claims **characterised in that** said electrical means comprise a circuit intended to be interposed between the two terminals (7, 8) of said battery (1).

5. A device according to one of the preceding claims **characterised in that** said electrical means comprise a device for indicating the presence of current through said indicating member (9), for example a light emitting diode (15).

6. A device according to claim 5 **characterised in that** said circuit further comprises a resistor (19) connected in series with said indicating member (9), said resistor (19) being adapted to prevent the establishment of an electrolysis current which can flow after opening of said indicating member (9).

7. A device according to one of the preceding claims **characterised in that** the indicating conductor element (9) is formed of a metal alloy.

8. A device according to one of the preceding claims **characterised in that** said electrical means (15, 17, 19) comprise a switch (17) for initialising a circuit test through the indicating member (9).

9. A battery (1) comprising electrodes (3) immersed in an electrolyte (5), **characterised in that** it is equipped with a device according to any one of the preceding claims for diagnosing the degree of corrosion of parts of some of said electrodes (3).

10. A battery (1) according to claim 9 **characterised in that** said device is integrated in the cover of said battery (1).

11. A battery (1) according to one of claims 9 and 10 **characterised in that** said some electrodes are anodes.

12. A battery (1) according to claim 11 **characterised in that** said parts of electrodes are metallic grids of said anodes.

13. A battery according to one of claims 9 to 12 **characterised in that** said indicating conductor element (9) of said device is directly conductingly connected to the positive terminal (7) of said battery.

Fig. 1

Fig. 2

Fig. 3

Fig. 4